# EUROPÄISCHE PATENTSCHRIFT

(11) **EP 3 084 765 B1**
(45) Veröffentlichungstag und Bekanntmachung des Hinweises auf die Patenterteilung: **15.07.2020**
(21) Anmeldenummer: 14812248.4
(22) Anmeldetag: 16.12.2014
(51) Int. Cl.: G11B 7/24044, G03F 7/00, G03F 7/035, G11B 7/245, G03F 7/027, G03H 1/02

(54) **HOLOGRAPHISCHE MEDIEN MIT VERBESSERTER LICHTEMPFINDLICHKEIT**
HOLOGRAPHIC MEDIA WITH INCREASED PHOTOSENSITIVITY
SUPPORTS HOLOGRAPHIQUES À PHOTOSENSIBILITÉ AMÉLIORÉE

(30) Priorität: 20.12.2013 EP 13198913
(43) Veröffentlichungstag der Anmeldung: 26.10.2016
(73) Patentinhaber: Covestro Deutschland AG, 51373 Leverkusen (DE)
(72) Erfinder: RÖLLE, Thomas, 51381 Leverkusen (DE); BERNETH, Horst, 51373 Leverkusen (DE); BRUDER, Friedrich-Karl, 47802 Krefeld (DE); HÖNEL, Dennis, 53909 Zülpich-Wichterich (DE); FÄCKE, Thomas, 51375 Leverkusen (DE); WALZE, Günther, 51377 Leverkusen (DE); HAGEN, Rainer, 51377 Leverkusen (DE); DIEDRICH, Christian, 40591 Düsseldorf (DE)
(74) Vertreter: Levpat
(86) Internationale Anmeldenummer: PCT/EP2014/077878
(87) Internationale Veröffentlichungsnummer: WO 2015/091427

(56) Entgegenhaltungen:
- WO-A1-2011/095442
- WO-A1-2013/053771

## Beschreibung

Die vorliegende Erfindung betrifft eine Photopolymer-Formulierung umfassend Matrixpolymere, ein Schreibmonomer und einen Photoinitiator. Weitere Gegenstände der Erfindung sind ein Photopolymer umfassend Matrixpolymere, ein Schreibmonomer und einen Photoinitiator, ein holographisches Medium, das ein erfindungsgemäßes Photopolymer enthält, die Verwendung eines erfindungsgemäßen holographischen Mediums sowie ein Verfahren zur Herstellung eines holographischen Mediums unter Verwendung einer erfindungsgemäßen Photopolymer-Formulierung.

Photopolymer-Formulierungen der eingangs genannten Art sind im Stand der Technik bekannt. So sind beispielsweise in der WO 2008/125229 A1 eine Photopolymer-Formulierung und ein daraus erhältliches Photopolymer beschrieben, die Polyurethanmatrixpolymere, ein Schreibmonomer auf Acrylatbasis sowie Photoinitiatoren enthaltend einen Coinitiator und einen Farbstoff umfassen. Bei der Verwendungen von Photopolymeren spielt die durch die holographische Belichtung erzeugte Brechungsindexmodulation Δn die entscheidende Rolle. Bei der holographischen Belichtung wird das Interferenzfeld aus Signal- und Referenzlichtstrahl (im einfachsten Fall das zweier ebener Wellen) durch die lokale Photopolymerisation von Schreibmonomeren wie z.B. hochbrechenden Acrylate an Orten hoher Intensität im Interferenzfeld in ein Brechungsindexgitter abgebildet. Das Brechungsindexgitter im Photopolymer (das Hologramm) enthält alle Information des Signallichtstrahls. Durch Beleuchtung des Hologramms nur mit dem Referenzlichtstrahl kann dann das Signal wieder rekonstruiert werden. Die Stärke des so rekonstruierten Signals im Verhältnis zur Stärke des eingestrahlten Referenzlichts wird Beugungseffizienz, im Folgenden DE wie Diffraction Efficiency, genannt.

Im einfachsten Fall eines Hologramms, das aus der Überlagerung zweier ebener Wellen entsteht, ergibt sich die DE aus dem Quotienten der Intensität des bei der Rekonstruktion abgebeugten Lichtes und der Summe der Intensitäten aus nicht gebeugten und abgebeugtem Licht. Je höher die DE desto effizienter ist ein Hologramm in Bezug auf die Lichtmenge des Referenzlichtes die notwendig ist, um das Signal mit einer festen Helligkeit sichtbar zu machen.

Um ein möglichst hohes Δn und eine möglichst hohe DE bei Hologrammen realisieren zu können, sollten grundsätzlich die Matrixpolymere und die Schreibmonomere einer Photopolymer-Formulierung so gewählt werden, dass sie sich in ihren Brechungsindizes möglichst stark unterscheiden. Ein Möglichkeit zur Realisierung ist, Matrixpolymere mit einem möglichst niedrigen und Schreibmonomere mit einem möglichst hohen Brechungsindex zu verwenden. Geeignete Matrixpolymere mit niedrigem Brechungsindex sind beispielsweise durch Umsetzung einer Polyol- mit einer Polyisocyanat-Komponente erhältliche Polyurethane.

Neben hohen DE- und Δn- Werten ist es für holographische Medien aus Photopolymer-Formulierungen aber auch von großer Bedeutung, dass die Matrixpolymere im fertigen Medium hoch vernetzt sind. Falls der Vernetzungsgrad zu niedrig ist, weist das Medium keine ausreichende Stabilität auf. Dies kann dazu führen, dass die Qualität von in die Medien eingeschriebenen Hologrammen erheblich vermindert ist. Im schlimmsten Fall können die Hologramme sogar nachträglich zerstört werden.

Weiterhin ist es insbesondere für den großtechnischen Einsatz von holographischen Medien aus Photopolymer-Formulierungen von großer Bedeutung, dass die Lichtempfindlichkeit ausreicht, um bei einer gegebenen Laser-Lichtquelle großflächig und ohne Verlust an Indexmodulation belichten zu können. Hier ist insbesondere die Wahl eines geeigneten Photoinitiators von entscheidender Bedeutung für die Eigenschaften des Photopolymers.

Die holographische Belichtung mit einer kontinuierlichen Laserquelle stößt jedoch bei großflächiger Belichtung an technische Grenzen, da immer eine gewisse Lichtdosis pro Flächeneinheit eingestrahlt werden muss, um eine effiziente Bildung des Hologramms zu gewährleisten und die technisch verfügbare Laserleistung begrenzt ist. Zudem erfordern großflächige Belichtungen bei vergleichsweise geringer Dosis lange Belichtungszeiten, die wiederum sehr hohe Anforderungen an die mechanische Schwingungsdämpfung des Belichtungsaufbaus stellen.

Eine weitere Möglichkeit zur großflächigen Belichtung von Hologrammen besteht in der Verwendung von sehr kurzen Lichtpulsen, wie sie z.B. von gepulsten Lasern oder Dauerstrichlasern in Verbindung mit sehr schnellen Shuttern erzeugt werden. Typische Pulsdauern bei gepulsten Lasern sind 500 ns oder kürzer. Typische Pulsdauern bei Dauerstrichlasern mit sehr schnellen Shuttern sind 100 µs oder kürzer. Dabei kann die gleiche Energiedosis eingestrahlt werden wie mit kontinuierlichen Lasern in Sekunden. Auf diese Art können Hologramme Punkt für Punkt geschrieben werden. Da gepulste Laser oder schnelle optische Shutter technisch verfügbar sind und ein derartiger Belichtungsaufbau sehr geringe Anforderungen mit Hinblick auf die mechanische Schwingungsdämpfung hat, handelt es sich um eine gute technisch Alternative zu den oben beschriebenen Aufbauten mit kontinuierlichen Lasern zur großflächigen Belichtung von Hologrammen.

Die aus der WO 2008/125229 A1 bekannten Photopolymere weisen auf Grund der dort verwendeten Photoinitiatoren eine zu geringe Lichtempfindlichkeit auf, um sie beim Schreiben von Hologrammen mit gepulsten Lasern verwenden zu können. Weitere Photopolymer-Formulierungen die Matrixpolymere, Schreibmonomere und Photoinitiatoren enthalten sind aus der WO 2013/053771 A und der WO 2011/095442 A1 bekannt.

Die Aufgabe der vorliegenden Erfindung bestand daher darin, eine Photopolymer-Formulierung bereit zu stellen, mit deren Hilfe sich Photopolymere herstellen lassen, in die auf Grund ihrer höheren Lichtempfindlichkeit mit gepulsten Lasern Hologramme geschrieben werden können.

Diese Aufgabe ist durch eine Photopolymer-Formulierung umfassend Matrixpolymere, ein Schreibmonomer und einen Photoinitiator gelöst, die zusätzlich eine Verbindung der Formel (I) umfasst 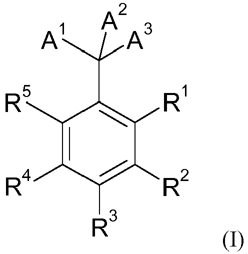 worin
- A¹, A², A³: jeweils unabhängig voneinander Wasserstoff, Fluor, Chlor, Brom oder Iod,
- R¹, R², R³, R⁴, R⁵: jeweils unabhängig voneinander Wasserstoff, Halogen, Cyano, Nitro, Amino, Alkylimino, Azid, Isonitril, Enamino, Formyl, Acyl, Carboxyl, Carbonester, Carbonamid, Orthoester, Sulfonat, Phosphat, Organosulfonyl, Organo-sulfoxidyl, gegebenenfalls fluoriertes Alkoxy oder ein gegebenenfalls substituierter aromatischer, heteroaromatischer, aliphatischer, araliphatischer, olefinischer oder acetylenischer Rest sind und geeignete Reste über eine Brücke beliebiger Substitution miteinander verbunden sein können oder dass zwei oder mehrere Verbindungen der Formel (I) über mindestens einen der Reste R¹, R², R³, R⁴, R⁵ verbunden sein können, wobei diese Reste dann eine 2 - 4-fach funktionelle Brücke darstellen können, mit der Maßgabe, dass wenigstens einer der Reste R¹, R², R³, R⁴, R⁵ nicht Wasserstoff ist.

So wurde überraschenderweise gefunden, dass Medien, die aus einer erfindungsgemäßen Photopolymer-Formulierung hergestellt sind, eine höhere Lichtempfindlichkeit aufweisen und damit gut zur Belichtung mit gepulsten Lasern geeignet sind.

Gemäß einer bevorzugten Ausführungsform der erfindungsgemäßen Photopolymer-Formulierung ist vorgesehen, dass bei der Verbindung der Formel (I) A¹, A² und A³ jeweils unabhängig voneinander Fluor, Chlor, Brom oder Iod und weiter bevorzugt A¹, A² und A³ gleichzeitig entweder Fluor, Chlor, Brom oder Iod sind.

Ebenfalls bevorzugt ist, wenn bei der Verbindung der Formel (I) R¹, R², R³, R⁴, R⁵ jeweils unabhängig voneinander Wasserstoff, Halogen, Cyano, Nitro, Isonitril, Acyl, Carboxyl, Carbonester, Carbonamid, Orthoester, Sulfonat, Phosphat, Organo-sulfonyl, Organo-sulfoxidyl, gegebenenfalls fluoriertes Alkoxy und bevorzugt Wasserstoff, Halogen, Cyano, Nitro, Isonitril, Acyl, Carboxyl, weiter bevorzugt Wasserstoff, Halogen und besonders bevorzugt Wasserstoff, Fluor, Chlor, Brom oder Iod sind.

Die Matrixpolymere der erfindungsgemäßen Photopolymer-Formulierung können insbesondere vernetzt und besonders bevorzugt dreidimensional vernetzt sein.

Vorteilhaft ist auch, wenn die Matrixpolymere Polyurethane sind, wobei die die Polyurethane insbesondere durch Umsetzung wenigstens einer Polyisocyanat-Komponente a) mit wenigstens einer Isocyanat-reaktiven-Komponente b) erhältlich sein können

Die Polyisocyanat-Komponente a) umfasst bevorzugt wenigstens eine organische Verbindung mit wenigstens zwei NCO-Gruppen. Bei diesen organischen Verbindungen kann es sich insbesondere um monomere Di- und Triisocyanate, Polyisocyanate und / oder NCO-funktionelle Prepolymere handeln. Die Polyisocyanat-Komponente a) kann auch Mischungen monomerer Di- und Triisocyanate, Polyisocyanate und / oder NCO-funktioneller Prepolymere enthalten oder daraus bestehen.

Als monomere Di- und Triisocyanate können alle dem Fachmann an sich gut bekannten Verbindungen oder deren Mischungen eingesetzt werden. Diese Verbindungen können aromatische, araliphatische, aliphatische oder cycloaliphatische Strukturen aufweisen. In untergeordneten Mengen können die monomeren Di- und Triisocyanate auch Monoisocyanate, d.h. organische Verbindungen mit einer NCO-Gruppe umfassen.

Beispiele für geeignete monomere Di- und Triisocyanate sind 1,4-Butandiisocyanat, 1,5-Pentandiisocyanat, 1,6-Hexandiisocyanat (Hexamethylendiisocyanat, HDI), 2,2,4-Trimethylhexamethylendiisocyanat und / oder 2,4,4-Trimethylhexamethylendiisocyanat (TMDI), Isophorondiisocyanat (IPDI), 1,8-Diisocyanato-4-(isocyanatomethyl)-octan, Bis-(4,4'-isocyanatocyclohexyl)methan und / oder Bis-(2',4-isocyanatocyclohexyl)methan und / oder deren Mischungen beliebigen Isomerengehalts, 1,4-Cyclohexandiisocyanat, die isomeren Bis-(isocyanatomethyl)cyclohexane, 2,4- und / oder 2,6-Diisocyanato-1-methylcyclohexan (Hexahydro-2,4- und / oder 2,6-toluylendiisocyanat, H₆-TDI), 1,4-Phenylendiisocyanat, 2,4- und / oder 2,6-Toluylendiisocyanat (TDI), 1,5-Naphthylendiisocyanat (NDI), 2,4'- und / oder 4,4'-Diphenylmethandiisocyanat (MDI), 1,3-Bis-(isocyanatomethyl)benzol (XDI) und / oder das analoge 1,4-Isomere oder beliebige Mischungen der vorgenannten Verbindungen.

Geeignete Polyisocyanate sind Verbindungen mit Urethan-, Harnstoff-, Carbodiimid-, Acylharnstoff-, Amid-, Isocyanurat-, Allophanat-, Biuret-, Oxadiazintrion-, Uretdion- und/oder Iminooxadiazindionstrukturen, die aus den vorgenannten Di- oder Triisocyanaten erhältlich sind.

Besonders bevorzugt handelt es sich bei den Polyisocyanaten um oligomerisierte aliphatische und / oder cycloaliphatische Di- oder Triisocyanate, wobei insbesondere die oben stehenden aliphatischen und / oder cycloaliphatischen Di- oder Triisocyanate verwendet werden können.

Ganz besonders bevorzugt sind Polyisocyanate mit Isocyanurat-, Uretdion- und / oder Iminooxadiazindion-Strukturen sowie Biurete basierend auf HDI oder deren Mischungen.

Geeignete Prepolymere enthalten Urethan- und / oder Harnstoff-Gruppen sowie gegebenenfalls weitere durch Modifizierung von NCO-Gruppen entstandene Strukturen wie oben genannt. Derartige Prepolymere sind beispielsweise durch Umsetzung der oben genannten monomeren Di- und Triisocyanate und / oder Polyisocyanaten a1) mit isocyanatreaktiven Verbindungen b1) erhältlich.

Als isocyanatreaktive Verbindungen b1) können Alkohole, Amino oder Mercapto-Verbindungen, bevorzugt Alkohole, verwendet werden. Dabei kann es sich insbesondere um Polyole handeln. Ganz besonders bevorzugt können als isocyanatreaktive Verbindung b1) Polyester-, Polyether-, Polycarbonat-, Poly(meth)acrylat- und/oder Polyurethan-Polyole verwendet werden.

Als Polyesterpolyole sind beispielsweise lineare Polyesterdiole oder verzweigte Polyesterpolyole geeignet, die in bekannter Weise durch Umsetzung von aliphatischen, cycloaliphatischen oder aromatischen Di- bzw. Polycarbonsäuren bzw. ihren Anhydriden mit mehrwertigen Alkoholen einer OH-Funktionalität ≥ 2 erhalten werden können. Beispiele für geeignete Di- bzw. Polycarbonsäuren sind mehrwertige Carbonsäuren wie Bernstein-, Adipin-, Kork-, Sebacin-, Decandicarbon-, Phthal-, Terephthal-, Isophthal- Tetrahydrophthal- oder Trimellithsäure sowie Säureanhydride wie Phthal-, Trimellith- oder Bernsteinsäureanhydrid oder deren beliebige Gemische untereinander. Die Polyesterpolyole können auch auf natürlichen Rohstoffen wie Rizinusöl basieren. Es ist ebenfalls möglich, dass die Polyesterpolyole auf Homo- oder Mischpolymerisaten von Lactonen basieren, die bevorzugt durch Anlagerung von Lactonen bzw. Lactongemischen wie Butyrolacton, ε-Caprolacton und / oder Methyl-ε-caprolacton an hydroxyfunktionelle Verbindungen wie mehrwertige Alkohole einer OH-Funktionalität ≥ 2 beispielsweise der nachstehend genannten Art erhalten werden können.

Beispiele für geeignete Alkohole sind alle mehrwertigen Alkohole wie z.B. die C₂ - C₁₂-Diole, die isomeren Cyclohexandiole, Glycerin oder deren beliebige Gemische untereinander.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkohole einer OH-Funktionalität ≥ 2, bevorzugt Butandiol-1,4, Hexandiol-1,6 und / oder 3-Methylpentandiol. Auch Polyesterpolyole können zu Polycarbonatpolyolen umgearbeitet werden.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin sowie ihre beliebigen Mischungen.

Als Starter können die an sich im Rahmen der Polyesterpolyole genannten mehrwertigen Alkohole einer OH-Funktionalität ≥ 2 sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden. Besonders bevorzugt sind Propylenoxid-homopolymere sowie statistische oder Block-Copolymere, die Oxyethylen-, Oxypropylen- und / oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.-% ausmacht. Oxypropylen- und Oxybutylen umfasst hierbei alle jeweiligen linearen und verzweigten C₃- und C₄-Isomere.

Daneben sind als Bestandteile der Polyol-Komponente b1) als polyfunktionelle, isocyanatreaktive Verbindungen auch niedermolekulare, d.h. mit Molekulargewichten ≤ 500 g/mol, kurzkettige, d.h. 2 bis 20 Kohlenstoffatome enthaltende aliphatische, araliphatische oder cycloaliphatische di-, tri- oder polyfunktionelle Alkohole geeignet.

Dies können beispielsweise in Ergänzung zu den oben genannten Verbindungen Neopentylglykol, 2-Ethyl-2-butylpropandiol, Trimethylpentandiol, stellungs-isomere Diethyloctandiole, Cyclohexandiol, 1,4-Cyclohexandimethanol, 1,6-Hexandiol, 1,2- und 1,4-Cyclohexandiol, hydriertes Bisphenol A, 2,2-Bis(4-hydroxy-cyclohexyl)-propan oder 2,2-Dimethyl-3-hydroxypropionsäure, 2,2-dimethyl-3-hydroxypropyl-ester sein. Beispiele geeigneter Triole sind Trimethylolethan, Trimethylolpropan oder Glycerin. Geeignete höherfunktionelle Alkohole sind Di-(trimethylolpropan), Pentaerythrit, Dipenta-erythrit oder Sorbit.

Besonders bevorzugt ist, wenn die Polyolkomponente ein difunktioneller Polyether-, Polyester oder ein Polyether-polyester-block-copolyester oder ein Polyether-Polyester-Blockcopolymer mit primären OH-Funktionen ist.

Es ist ebenfalls möglich, als isocyanatreaktive Verbindungen b1) Amine einzusetzen. Beispiele geeigneter Amine sind Ethylendiamin, Propylendiamin, Diaminocyclohexan, 4,4'-Dicylohexylmethandiamin, Isophorondiamin (IPDA), difunktionelle Polyamine wie z.B. die Jeffamine®, aminterminierte Polymere, insbesondere mit zahlenmittleren Molmassen ≤ 10000 g/Mol. Mischungen der vorgenannten Amine können ebenfalls verwendet werden.

Es ist ebenfalls möglich, als isocyanatreaktive Verbindungen b1) Aminoalkohole einzusetzen. Beispiele geeigneter Aminoalkohole sind die isomeren Aminoethanole, die isomere Aminopropanole die isomeren Aminobutanole und die isomeren Aminohexanole oder deren beliebige Mischungen.

Alle vorgenannten isocyanatreaktiven Verbindungen b1) können untereinander beliebig vermischt werden.

Bevorzugt ist auch, wenn die isocyanatreaktiven Verbindungen b1) eine zahlenmittlere Molmasse von ≥ 200 und ≤ 10000 g/Mol, weiter bevorzugt ≥ 500 und ≤ 8000 g/Mol und ganz besonders bevorzugt ≥ 800 und ≤ 5000 g/Mol aufweisen. Die OH-Funktionalität der Polyole beträgt bevorzugt 1.5 bis 6.0, besonders bevorzugt 1.8 bis 4.0.

Die Prepolymere der Polyisocyanat-Komponente a) können insbesondere einen Restgehalt an freiem monomeren Di- und Triisocyanaten < 1 Gew.-%, besonders bevorzugt < 0.5 Gew.-% und ganz besonders bevorzugt < 0.3 Gew.-% aufweisen.

Es ist gegebenenfalls auch möglich, dass die Polyisocyanat-Komponente a) vollständig oder anteilsmäßig organische Verbindung enthält, deren NCO-Gruppen ganz oder teilweise mit aus der Beschichtungstechnologie bekannten Blockierungsmitteln umgesetzt sind. Beispiel für Blockierungsmittel sind Alkohole, Lactame, Oxime, Malonester, Pyrazole sowie Amine, wie z.B. Butanonoxim, Diisopropylamin, Malonsäurediethylester, Acetessigester, 3,5-Dimethylpyrazol, ε-Caprolactam, oder deren Mischungen.

Besonders bevorzugt ist, wenn die Polyisocyanat-Komponente a) Verbindungen mit aliphatisch gebundenen NCO-Gruppen umfasst, wobei unter aliphatisch gebundenen NCO-Gruppen derartige Gruppen verstanden werden, die an ein primäres C-Atom gebunden sind. Die isocyanatreaktive Komponente b) umfasst bevorzugt wenigstens eine organische Verbindung, die im Mittel wenigstens 1.5 und bevorzugt 2 bis 3 isocyanatreaktive Gruppen aufweist. Im Rahmen der vorliegenden Erfindung werden als isocyanatreaktive Gruppen bevorzugt Hydroxy-, Amino- oder MercaptoGruppen angesehen.

Die isocyanatreaktive Komponente kann insbesondere Verbindungen umfassen, die im Zahlenmittel wenigstens 1.5 und bevorzugt 2 bis 3 isocyanatreaktive Gruppen aufweisen.

Geeignete polyfunktionelle, isocyanatreaktive Verbindungen der Komponente b) sind beispielsweise die oben beschriebenen Verbindungen b1).

Bei einer weiteren bevorzugten Ausführungsform ist vorgesehen, dass das Schreibmonomer c) wenigstens ein mono- und / oder ein multifunktionales Schreibmonomer umfasst oder daraus besteht. Weiter bevorzugt kann das Schreibmonomer wenigstens ein mono- und / oder ein multifunktionelles (Meth)acrylat-Schreibmonomer umfassen oder daraus bestehen. Ganz besonders bevorzugt kann das Schreibmonomer wenigstens ein mono- und / oder ein multifunktionelles Urethan-(meth)acrylat umfassen oder daraus bestehen.

Geeignete Acrylat-Schreibmonomere sind insbesondere Verbindungen der allgemeinen Formel (II) 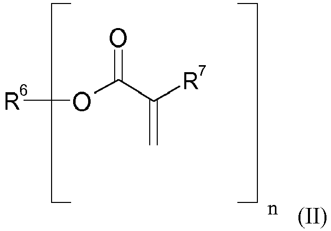 bei denen n≥1 und n≤4 ist und R⁶ ein linearer, verzweigter, cyclischer oder heterocyclischer unsubstituierter oder gegebenenfalls auch mit Heteroatomen substituierter organischer Rest und/oder R⁷ Wasserstoff, ein linearer, verzweigter, cyclischer oder heterocyclischer unsubstituierter oder gegebenenfalls auch mit Heteroatomen substituierter organischer Rest ist. Besonders bevorzugt ist R⁷ Wasserstoff oder Methyl und/oder R⁶ ein linearer, verzweigter, cyclischer oder heterocyclischer unsubstituierter oder gegebenenfalls auch mit Heteroatomen substituierter organischer Rest.

Als Acrylate bzw. Methacrylate werden vorliegend Ester der Acrylsäure bzw. Methacrylsäure bezeichnet. Beispiele bevorzugt verwendbarer Acrylate und Methacrylate sind Phenylacrylat, Phenylmethacrylat, Phenoxyethylacrylat, Phenoxyethylmethacrylat, Phenoxyethoxyethylacrylat, Phenoxyethoxyethylmethacrylat, Phenylthioethylacrylat, Phenylthioethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Bisphenol A Diacrylat, Bisphenol A Dimethacrylat, sowie deren ethoxylierte Analogverbindungen, N-Carbazolylacrylate.

Als Urethanacrylate werden vorliegend Verbindungen mit mindestens einer Acrylsäureestergruppe und mindestens eine Urethanbindung verstanden. Solche Verbindungen können beispielsweise durch Umsetzung eines Hydroxy-funktionellen Acrylats oder Methacrylats mit einer Isocyanatfunktionellen Verbindung erhalten werden.

Beispiele hierfür verwendbarer Isocyanat-funktionelle Verbindungen sind Monoisocyanate sowie die unter a) genannten monomeren Diisocyanate, Triisocyanate und / oder Polyisocyanate. Beispiele geeigneter Monoisocyanate sind Phenylisocyanat, die isomeren Methylthiophenylisocyanate. Di-, Tri- oder Polyisocyanate sind oben genannt sowie Triphenylmethan-4,4',4"-triisocyanat und Tris-(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische Di-, Tri- oder Polyisocyanate.

Als hydroxyfunktionelle Acrylate oder Methacrylate für die Herstellung von Urethanacrylaten kommen beispielsweise Verbindungen wie 2-Hydroxyethyl(meth)acrylat, Polyethylenoxid-mono-(meth)acrylate, Polypropylenoxidmono(meth)acrylate, Polyalkylenoxidmono(meth)-acrylate, Poly-(ε-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly(ε-caprolacton)mono-(meth)acrylat.

Ebenfalls verwendet werden können die an sich bekannten hydroxylgruppenhaltigen Epoxy(meth)-acrylate mit OH-Gehalten von 20 bis 300 mg KOH/g oder hydroxylgruppenhaltige Polyurethan-(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten.

Bevorzugt sind insbesondere Urethanacrylate erhältlich aus der Umsetzung von Tris(p-isocyanatophenyl)thiophosphat und / oder m-Methylthiophenylisocyanat mit alkoholfunktionellen Acrylaten wie Hydroxyethyl(meth)acrylat, Hydroxypropyl(meth)acrylat und / oder Hydroxybutyl(meth)-acrylat.

Ebenso ist es möglich, dass das Schreibmonomer weitere ungesättigte Verbindungen wie α,β-ungesättigte Carbonsäurederivate wie beispielsweise Maleinate, Fumarate, Maleimide, Acrylamide, weiterhin Vinylether, Propenylether, Allylether und Dicyclopentadienyl-Einheiten enthaltende Verbindungen sowie olefinisch ungesättigte Verbindungen wie z.B. Styrol, α-Methylstyrol, Vinyltoluol und / oder Olefine, umfasst oder daraus besteht.

Photoinitiatoren der Komponente d) sind üblicherweise durch aktinische Strahlung aktivierbare Verbindungen, die eine Polymerisation der Schreibmonomere auslösen können. Bei den Photoinitiatoren kann zwischen unimolekularen (Typ I) und bimolekularen (Typ II) Initiatoren unterschieden werden. Des Weiteren werden sie je nach ihrer chemischen Natur in Photoinitiatoren für radikalische, anionische, kationische oder gemischte Art der Polymerisation unterschieden.

Typ I-Photoinitiatoren (Norrish-Typ-I) für die radikalische Photopolymerisation bilden beim Bestrahlen durch eine unimolekulare Bindungsspaltung freie Radikale. Beispiele für Typ I-Photoinitiatoren sind Triazine, Oxime, Benzoinether, Benzilketale, Bis-imidazole, Aroylphosphinoxide, Sulfonium- und Iodoniumsalze.

Typ II-Photoinitiatoren (Norrish-Typ-II) für die radikalische Polymerisation bestehen aus einem Farbstoff als Sensibilisator und einem Coinitiator und durchlaufen bei der Bestrahlung mit auf den Farbstoff angepasstem Licht eine bimolekulare Reaktion. Zunächst absorbiert der Farbstoff ein Photon und überträgt aus einem angeregten Zustand Energie auf den Coinitiator. Dieser setzt durch Elektronen- oder Protonentransfer oder direkte Wasserstoffabstraktion die polymerisationsauslösenden Radikale frei.

Im Sinne dieser Erfindung werden bevorzugt Typ II-Photoinitiatoren verwendet.

Solche Photoinitiatorsysteme sind prinzipiell in der EP 0 223 587 A beschriebenen und bestehen bevorzugt aus einer Mischung von einem oder mehreren Farbstoffen mit Ammoniumalkylarylborat(en).

Geeignete Farbstoffe, die zusammen mit einem Ammoniumalkylarylborat einen Typ II-Photoinitiator bilden, sind die in der WO 2012062655 beschriebenen kationischen Farbstoffe in Kombination mit den eben dort beschriebenen Anionen.

Unter kationischen Farbstoffen werden bevorzugt solche der folgenden Klassen verstanden: Acridin-Farbstoffe, Xanthen-Farbstoffe, Thioxanthen-Farbstoffe, Phenazin-Farbstoffe, Phenoxazin-Farbstoffe, Phenothiazin-Farbstoffe, Tri(het)arylmethan-Farbstoffe - insbesondere Diamino- und Triamino(het)arylmethan-Farbstoffe, Mono-, Di-, Tri- und Pentamethincyanin-Farbstoffe, Hemicyanin-Farbstoffe, extern kationische Merocyanin-Farbstoffe, extern kationische Neutrocyanin-Farbstoffe, Nullmethin-Farbstoffe - insbesondere Naphtholactam-Farbstoffe, Streptocyanin-Farbstoffe. Solche Farbstoffe sind beispielsweise in H. Berneth in Ullmann's Encyclopedia of Industrial Chemistry, Azine Dyes, Wiley-VCH Verlag, 2008, H. Berneth in Ullmann's Encyclopedia of Industrial Chemistry, Methine Dyes and Pigments, Wiley-VCH Verlag, 2008, T. Gessner, U. Mayer in Ullmann's Encyclopedia of Industrial Chemistry, Triarylmethane and Diarylmethane Dyes, Wiley-VCH Verlag, 2000 beschrieben.

Besonders bevorzugt sind Phenazin-Farbstoffe, Phenoxazin-Farbstoffe, Phenothiazin-Farbstoffe, Tri(het)arylmethan-Farbstoffe - insbesondere Diamino- und Triamino(het)arylmethan-Farbstoffe, Mono-, Di-, Tri- und Pentamethincyanin-Farbstoffe, Hemicyanin-Farbstoffe, Nullmethin-Farbstoffe - insbesondere Naphtholactam-Farbstoffe, Streptocyanin-Farbstoffe.

Beispiele für kationische Farbstoffe sind Astrazon Orange G, Basic Blue 3, Basic Orange 22, Basic Red 13, Basic Violett 7, Methylenblau, Neu Methylenblau, Azur A, 2,4-Diphenyl-6-(4-methoxyphenyl)pyrylium, Safranin O, Astraphloxin, Brilliant Grün, Kristallviolett, Ethylviolett und Thionin.

Bevorzugte Anionen sind insbesondere C₈- bis C₂₅-Alkansulfonat, vorzugsweise C₁₃- bis C₂₅-Alkansulfonat, C₃- bis C₁₈-Perfluoralkansulfonat, C₄- bis C₁₈-Perfluoralkansulfonat, das in der Alkylkette mindestens 3 Wasserstoffatome trägt, C₉- bis C₂₅-Alkanoat, C₉- bis C₂₅-Alkenoat, C₈- bis C₂₅-Alkylsulfat, vorzugsweise C₁₃- bis C₂₅-Alkylsulfat, C₈- bis C₂₅-Alkenylsulfat, vorzugsweise C₁₃- bis C₂₅-Alkenylsulfat, C₃- bis C₁₈-Perfluoralkylsulfat, C₄- bis C₁₈-Perfluoralkylsulfat, das in der Alkylkette mindestens 3 Wasserstoffatome trägt, Polyethersulfate basierend auf mindestens 4 Äquivalenten Ethylenoxid und/oder 4 Äquivalenten Propylenoxid, Bis-C₄- bis C₂₅-Alkyl-, C₅- bis C₇-Cycloaₗkyl-, C₃- bis C₈-Alkenyl- oder C₇- bis C₁₁-Aralkyl-sulfosuccinat, durch mindestens 8 Fluoratome substituiertes Bis-C₂- bis C₁₀-alkyl-sulfosuccinat, C₈- bis C₂₅-Alkyl-sulfoacetate, durch mindestens einen Rest der Gruppe Halogen, C₄- bis C₂₅-Alkyl, Perfluor-C₁- bis C₈-Alkyl und/oder C₁- bis C₁₂-Alkoxycarbonyl substituiertes Benzolsulfonat, ggf. durch Nitro, Cyano, Hydroxy, C₁- bis C₂₅-Alkyl, C₁- bis C₁₂-Alkoxy, Amino, C₁- bis C₁₂-Alkoxycarbonyl oder Chlor substituiertes Naphthalin- oder Biphenylsulfonat, ggf. durch Nitro, Cyano, Hydroxy, C₁- bis C₂₅-Alkyl, C₁- bis C₁₂-Alkoxy, C₁- bis C₁₂-Alkoxycarbonyl oder Chlor substituiertes Benzol-, Naphthalin- oder Biphenyldisulfonat, durch Dinitro, C₆- bis C₂₅-Alkyl, C₄- bis C₁₂-Alkoxycarbonyl, Benzoyl, Chlorbenzoyl oder Toluoyl substituiertes Benzoat, das Anion der Naphthalindicarbonsäure, Diphenyletherdisulfonat, sulfonierte oder sulfatierte, ggf. mindestens einfach ungesättigte C₈- bis C₂₅-Fettsäureester von aliphatischen C₁- bis C₈-Alkoholen oder Glycerin, Bis-(sulfo-C₂- bis C₆-alkyl)-C₃- bis C₁₂-alkandicarbonsäureester, Bis-(sulfo-C₂- bis C₆-alkyl)-itaconsäureester, (Sulfo-C₂- bis C₆-alkyl)-C₆- bis C₁₈-alkancarbonsäureester, (Sulfo-C₂- bis C₆-alkyl)-acryl- oder methacrylsäureester, ggf. durch bis zu 12 Halogenreste substituiertes Triscatecholphosphat, ein Anion der Gruppe Tetraphenylborat, Cyanotriphenylborat, Tetraphenoxyborat, C₄- bis C₁₂-Alkyl-triphenylborat, deren Phenyl- oder Phenoxy-Reste durch Halogen, C₁- bis C₄-Alkyl und/oder C₁- bis C₄-Alkoxy substituiert sein können, C₄- bis C₁₂-Alkyl-trinaphthylborat, Tetra-Ci- bis C₂₀-alkoxyborat, 7,8- oder 7,9-Dicarba-nido-undecaborat(1-) oder (2-), die gegebenenfalls an den B- und/oder C-Atomen durch eine oder zwei C₁- bis C₁₂-Alkyl- oder Phenyl-Gruppen substituiert sind, Dodecahydrodicarbadodecaborat(2-) oder B-C₁- bis C₁₂-Alkyl-C-phenyl-dodecahydro-dicarbadodecaborat(1-) steht, wobei bei mehrwertigen Anionen wie Naphthalindisulfonat A⁻ für ein Äquivalent dieses Anions steht, und wobei die Alkan- und Alkylgruppen verzweigt sein können und/oder durch Halogen, Cyano, Methoxy, Ethoxy, Methoxycarbonyl oder Ethoxycarbonyl substituiert sein können.

Bevorzugt ist auch, wenn das Anion A⁻ des Farbstoffs einen AClogP im Bereich von 1 bis 30, besonders bevorzugt im Bereich von 1 bis 12 und insbesondere bevorzugt im Bereich von 1 bis 6,5 aufweist. Der AClogP wird nach J. Comput. Aid. Mol. Des. 2005, 19, 453; Virtual Computational Chemistry Laboratory, http://www.vcclab.org berechnet.

Geeignete Ammoniumalkylarylborate sind beispielsweise (Cunningham et al., RadTech'98 North America UV/EB Conference Proceedings, Chicago, Apr. 19-22, 1998): Tetrabutylammonium Triphenylhexylborat, Tetrabutylammonium Triphenylbutylborat, Tetrabutylammonium Trinapthylhexylborat, Tetrabutylammonium Tris(4-tert.butyl)-phenylbutylborat, Tetrabutylammonium Tris-(3-fluorphenyl)-hexylborat hexylborat ([191726-69-9], CGI 7460, Produkt der BASF SE, Basel, Schweiz), 1-Methyl-3-octylimidazolium Dipentyldiphenylborat und Tetrabutylammonium Tris-(3-chlor-4-methylphenyl)-hexylborat ([1147315-11-4], CGI 909, Produkt der BASF SE, Basel, Schweiz).

Es kann vorteilhaft sein, Gemische dieser Photoinitiatoren einzusetzen. Je nach verwendeter Strahlungsquelle muss Typ und Konzentration an Photoinitiator in dem Fachmann bekannter Weise angepasst werden. Näheres ist zum Beispiel in P. K. T. Oldring (Ed.), Chemistry & Technology of UV & EB Formulations For Coatings, Inks & Paints, Vol. 3, 1991, SITA Technology, London, S. 61 - 328 beschrieben.

Ganz besonders bevorzugt ist, wenn der Photoinitiator eine Kombination von Farbstoffen, deren Absorptionsspektren zumindest teilweise den Spektralbereich von 400 bis 800 nm abdecken, mit wenigstens einem auf die Farbstoffe abgestimmten Coinitiator umfasst.

Bevorzugt ist auch, wenn wenigstens ein für eine Laserlichtfarbe ausgewählt aus blau, grün und rot geeigneter Photoinitiator in der Photopolymer-Formulierung enthalten ist.

Weiter bevorzugt ist auch, wenn die Photopolymer-Formulierung für wenigstens zwei Laserlichtfarben ausgewählt aus blau, grün und rot je einen geeigneten Photoinitiator enthält.

Ganz besonders bevorzugt ist schließlich, wenn die Photopolymer-Formulierung für jede der Laserlichtfarben blau, grün und rot jeweils einen geeigneten Photoinitiator enthält.

Gemäß einer weiteren bevorzugten Ausführungsform ist vorgesehen, dass die Photopolymer-Formulierung zusätzlich Urethane als Additive enthält, wobei die Urethane insbesondere mit wenigstens einem Fluoratom substituiert sein können.

Bevorzugt können die Urethane die allgemeine Formel (III) 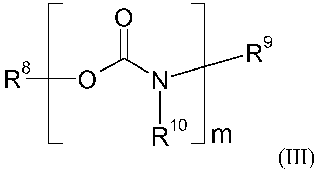 haben, in der m≥1 und m≤8 ist und R⁸, R⁹ und R¹⁰ lineare, verzweigte, cyclische oder heterocyclische unsubstituierte oder gegebenenfalls auch mit Heteroatomen substituierte organische Reste und/oder R⁹, R¹⁰ unabhängig voneinander Wasserstoff sind, wobei bevorzugt mindestens einer der Reste R⁸, R⁹, R¹⁰ mit wenigstens einem Fluoratom substituiert ist und besonders bevorzugt R⁸ ein organischer Rest mit mindestens einem Fluoratom ist. Besonders bevorzugt ist R⁹ ein linearer, verzweigter, cyclischer oder heterocyclischer unsubstituierter oder gegebenenfalls auch mit Heteroatomen wie beispielsweise Fluor substituierter organischer Rest.

Ein weiterer Gegenstand der vorliegenden Erfindung ist ein Photopolymer umfassend Matrixpolymere, ein Schreibmonomer und einen Photoinitiator, das zusätzlich eine Verbindung der Formel (I) umfasst 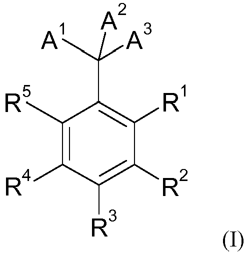 worin
- A¹, A², A³: jeweils unabhängig voneinander Wasserstoff, Fluor, Chlor, Brom oder Iod,
- R¹, R², R³, R⁴, R⁵: jeweils unabhängig voneinander Wasserstoff, Halogen, Cyano, Nitro, Amino, Alkylimino, Azid, Isonitril, Enamino, Formyl, Acyl, Carboxyl, Carbonester, Carbonamid, Orthoester, Sulfonat, Phosphat, Organosulfonyl, Organo-sulfoxidyl, gegebenenfalls fluoriertes Alkoxy oder ein gegebenenfalls substituierter aromatischer, heteroaromatischer, aliphatischer, araliphatischer, olefinischer oder acetylenischer Rest sind und geeignete Reste über eine Brücke beliebiger Substitution miteinander verbunden sein können oder dass zwei oder mehrere Verbindungen der Formel (I) über mindestens einen der Reste R¹, R², R³, R⁴, R⁵ verbunden sein können, wobei diese Reste dann eine 2 - 4-fach funktionelle Brücke darstellen können, mit der Maßgabe, dass wenigstens einer der Reste R¹, R², R³, R⁴, R⁵ nicht Wasserstoff ist. Gemäß einer bevorzugten Ausführungsform des erfindungsgemäßen Photopolymers ist vorgesehen, dass bei der Verbindung der Formel (I) A¹, A² und A³ jeweils unabhängig voneinander Fluor, Chlor, Brom oder Iod und weiter bevorzugt A¹, A² und A³ gleichzeitig entweder Fluor, Chlor, Brom oder Iod sind. Ebenfalls bevorzugt ist, wenn bei der Verbindung der Formel (I) R¹, R², R³, R⁴, R⁵ jeweils unabhängig voneinander Wasserstoff, Halogen, Cyano, Nitro, Isonitril, Acyl, Carboxyl, Carbonester, Carbonamid, Orthoester, Sulfonat, Phosphat, Organo-sulfonyl, Organo-sulfoxidyl, gegebenenfalls fluoriertes Alkoxy und bevorzugt Wasserstoff, Halogen, Cyano, Nitro, Isonitril, Acyl, Carboxyl, weiter bevorzugt Wasserstoff, Halogen und besonders bevorzugt Wasserstoff, Fluor, Chlor, Brom oder Iod sind.

Die Matrixpolymere des erfindungsgemäßen Photopolymers können insbesondere vernetzt und besonders bevorzugt dreidimensional vernetzt sein.

Vorteilhaft ist auch, wenn die Matrixpolymere Polyurethane sind, wobei die die Polyurethane insbesondere durch Umsetzung wenigstens einer Polyisocyanat-Komponente mit wenigstens einer Isocyanat-reaktiven Komponente erhältlich sein können.

Die oben zu der erfindungsgemäßen Photopolymer-Formulierung getroffenen Aussagen bezüglich weiterer bevorzugten Ausführungsformen gelten analog auch für das erfindungsgemäße Photopolymer.

Gegenstand der Erfindung ist auch ein holographisches Medium insbesondere in Form eines Films, enthaltend ein erfindungsgemäßes Photopolymer oder erhältlich unter Verwendung einer erfindungsgemäßen Photopolymer-Formulierung. Noch ein weiterer Gegenstand der Erfindung ist die Verwendung einer erfindungsgemäßen Photopolymer-Formulierung zur Herstellung holographischer Medien.

Bei einer bevorzugten Ausführungsform des erfindungsgemäßen holographisches Mediums sind in dieses holgraphische Informationen einbelichtet.

Die erfindungsgemäßen holographischen Medien können durch entsprechende Belichtungsprozesse für optische Anwendungen im gesamten sichtbaren und nahen UV-Bereich (300-800 nm) zu Hologrammen verarbeitet werden können. Visuelle Hologramme umfassen alle Hologramme, die nach dem Fachmann bekannten Verfahren aufgezeichnet werden können. Darunter fallen unter anderem In-Line (Gabor) Hologramme, Off-Axis Hologramme, Full-Aperture Transfer Hologramme, Weißlicht-Transmissionshologramme ("Regenbogenhologramme), Denisyukhologramme, Off-Axis Reflektionshologramme, Edge-Lit Hologramme sowie holographische Stereogramme. Bevorzugt sind Reflektionshologramme, Denisyukhologramme, Transmissionshologramme.

Mögliche optische Funktionen der Hologramme, die mit den erfindungsgemäßen Photopolymer-Formulierungen hergestellt werden können entsprechen den optische Funktionen von Lichtelementen wie Linsen, Spiegel, Umlenkspiegel, Filter, Streuscheiben, Beugungselemente, Diffusoren, Lichtleiter, Lichtlenker (waveguides), Projektionsscheiben und/oder Masken. Ebenfalls können Kombinationen aus dies optischen Funktionen unabhängig voneinander in einem Hologramm vereinigt sein. Häufig zeigen diese optischen Elemente eine Frequenzselektivität, je nachdem wie die Hologramme belichtet wurden und welche Dimensionen das Hologramm hat.

Zudem können mittels der erfindungsgemäßen Medien auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellten Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Design-Möglichkeiten stellen Hologramme, insbesondere Volumenhologramme, eine attraktive technische Lösung für die oben genannten Anwendung dar.

Weiterhin Gegenstand der vorliegenden Erfindung ist daher die Verwendung eines erfindungsgemäßen holographischen Mediums zur Aufzeichnung von In-Line, Off-Axis, Full-Aperture Transfer, Weißlicht-Transmissions, Denisyuk, Off-Axis Reflektions oder Edge-Lit Hologrammen sowie holographischen Stereogrammen, insbesondere zur Herstellung von optischen Elementen, Bildern oder Bilddarstellungen.

Weiterhin Gegenstand der vorliegenden Erfindung ist auch ein Verfahren zur Herstellung eines holographischen Mediums unter Verwendung einer erfindungsgemäßen Photopolymer-Formulierung.

Die Photopolymer-Formulierungen können insbesondere zur Herstellung holographischer Medien in Form eines Films verwendet werden. Dabei wird als Träger eine Lage eines für Licht im sichtbaren Spektralbereich (Transmission größer als 85% im Wellenlängenbereich von 400 bis 780 nm) transparenten Materials oder Materialverbunds ein- oder beidseitig beschichtet sowie ggf. eine Abdeckschicht auf der oder den Photopolymerlagen appliziert.

Bevorzugte Materialien oder Materialverbünde des Trägers basieren auf Polycarbonat (PC), Polyethylenterephthalat (PET), Polybutylenterephthalat, Polyethylen, Polypropylen, Celluloseacetat, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral oder Polydicyclopentadien oder deren Mischungen. Besonders bevorzugt basieren sie auf PC, PET und CTA. Materialverbünde können Folienlaminate oder Coextrudate sein. Bevorzugte Materialverbünde sind Duplex- und Triplexfolien aufgebaut nach einem der Schemata A/B, A/B/A oder A/B/C. Besonders bevorzugt sind PC/PET, PET/PC/PET und PC/TPU (TPU = Thermoplastisches Polyurethan).

Die Materialien oder Materialverbünde des Trägers können einseitig oder beidseitig antihaftend, antistatisch, hydrophobiert oder hydrophiliert ausgerüstet sein. Die genannten Modifikationen dienen an der Photopolymerschicht zugewandten Seite dem Zweck, dass die Photopolymerlage von dem Träger zerstörungsfrei abgelöst werden kann. Eine Modifikation der der Photopolymerlage abgewandten Seite des Trägers dient dazu, dass die erfindungsgemäßen Medien speziellen mechanischen Anforderungen genügen, die z.B. bei der Verarbeitung in Rollenlaminatoren, insbesondere bei Rolle-zu-Rolle-Verfahren, gefordert sind.

Die folgenden Beispiele dienen der beispielhaften Erläuterung der Erfindung.

### Beispiele

### Messmethoden:

### OH Zahl:

Die angegebenen OH-Zahlen wurden gemäß DIN 53240-2 bestimmt.

### NCO-Wert:

Die angegebenen NCO-Werte (Isocyanat-Gehalte) wurden gemäß DIN EN ISO 11909 bestimmt.

### Bestimmung der Beugungseffizienz bei Puls-Belichtung:

Zur Bestimmung der Beugungseffizienz bei Puls-Belichtung wurde das Denisyuk Hologramm eines Spiegels in eine Probe, bestehend aus einer Glasplatte mit auflaminiertem Photopolymerfilm, aufgezeichnet. Das Substrat des Photopolymerfilms zeigte dabei zur Laserquelle und das Glassubstrat zum Spiegel. Die Probe war bei der Belichtung mit ihrer Planfläche senkrecht zum Laserstrahl ausgerichtet. Der Abstand Probe zum Spiegel betrug 3 cm.

Als Laser wurde ein Puls-Laser der Firma Quantel aus Frankreich, Modell Brilliant b, verwendet. Es handelte sich dabei um einen Q-switched Nd-YAG Laser mit einem Modul zur Frequenzverdopplung zu 532 nm. Der Single Frequency Mode wurde durch einen Seed Laser garantiert. Die rechnerische Kohärenzlänge betrug ca. 1 m. Die Pulsdauer 4 ns und die mittlere Ausgangsleistung 3 Watt bei einer Pulswiederholungsrate von 10 Hz.

Mit dem elektronisch geregelten Shutter wurde eine Einfachpulsbelichtung sichergestellt. Die Wellenplatte erlaubte die Rotation der Polarisationsebene des Laserlichts und mit dem darauffolgenden Polarisator wurde der S-polarisierte Anteil des Laserlichtes in Richtung der Probe reflektiert. Die Strahlaufweitung erlaubte die Einstellung der belichteten Fläche. Die Wellenplatte und die Strahlaufweitung wurden so eingestellt, dass die Probe eine Belichtungsdosis von 100 mJ/cm²/Puls erreichte.

Zur Bestimmung der Beugungseffizienz wurden die Proben jeweils genau mit einem Puls belichtet. Nach der Belichtung wurde die Probe auf einem Leuchttisch geblichen.

Durch das Hologramm der geblichenen Probe wurde ein Transmissionsspektrum gemessen. Es wurde ein Spektrometer der Firma Ocean Optics, Modell HR4000 verwendet. Die Probe wurde senkrecht zum Lichtstrahl gestellt. Das Transmissionsspektrum zeigte bei der Wellenlänge, bei der die Bragg-Bedingung erfüllt war, einen Einbruch der Transmission. Die Tiefe des Transmissionseinbruchs zur Basislinie wurde als Beugungseffizienz DE des Denisyuk Hologramms des Spiegels ausgewertet.

### Substanzen:

Die verwendeten Lösungsmittel wurden im Chemikalienhandel bezogen.

| | |
|---|---|
| Desmorapid Z | Dibutylzinn-dilaurat [77-58-7], Produkt der Bayer MaterialScience AG, Leverkusen, Deutschland. |
| Desmodur® N 3900 | Produkt der Bayer MaterialScience AG, Leverkusen, DE, Hexandiisocyanat-basiertes Polyisocyanat, Anteil an Iminooxadiazindion mindestens 30 %, NCO-Gehalt: 23.5 %. |
| Fomrez UL 28 | Urethanisierungskatalysator, Handelsprodukt der Momentive Performance Chemicals, Wilton, CT, USA. |
| Aluminiumchlorid | [7446-70-0] ist bei Acros Organics, Geel, BE erhältlich. |
| 1-Chloro-3,4-difluorobenzol | [696-02-6] ist bei ABCR GmbH & CO. KG, Karlsruhe erhältlich. |
| 1-Bromo-3,4-difluorobenzol | [348-61-8] ist bei ABCR GmbH & CO. KG, Karlsruhe erhältlich. |
| 1,4-Difluorbenzol | [540-36-3] ist bei Aldrich Chemie, Steinheim erhältlich. |
| 4-Chlorofluorobenzol | [352-33-0] ist bei ABCR GmbH & CO. KG, Karlsruhe erhältlich. |
| 4-Bromfluorbenzol | [460-00-4] ist bei Aldrich Chemie, Steinheim erhältlich. |
| 4-Chlorphenylmagnesiumbromid | [873-77-8] ist als 0.9 M Lösung in THF/Toluol bei Aldrich Chemie, Steinheim erhältlich. |
| 4-Fluorphenylmagnesiumbromid | [352-13-6] ist als 1.0M Lösung in THF bei Aldrich Chemie, Steinheim erhältlich. |
| Tetrabutylammoniumbromid | [1643-19-2] ist bei ABCR GmbH & CO. KG, Karlsruhe erhältlich. |
| Safranin O | [10309-89-4] ist bei Chemos GmbH, Deutschland, Art.-Nr. 1308 erhältlich. Die Zusammensetzung des Substanzgemisches ist in EP 2450893 A1 beschrieben. |
| Natrium-bis(2-ethylhexyl)-sulfosuccinat | [45297-26-5] ist bei Aldrich Chemie, Steinheim erhältlich. |

### Verbindungen der Formel (I)

### Beispiel 1: 4-Fluortrichlorbenzol

4-Fluortrichlorbenzol [402-42-6] ist bei ABCR GmbH & CO. KG, Karlsruhe erhältlich und wurde eingesetzt wie erhalten.

### Beispiel 2: Herstellung von 1,2,4-Trifluor-5-(trichlormethyl)benzol :

In einem 250 mL Vierhals-Rundkolben mit Rückfluss-Kühler, Tropftrichter, Innenthermometer und mechanischem Rührer wurden unter Stickstoff 20.7 g Aluminiumtrichlorid in 75 mL Tetrachlorkohlenstoff suspendiert. Zu dieser Suspension wurden 10.2 g 1,2,4-Trifluorbenzol langsam zugeben, so dass das Reaktionsgemisch sanft refluxierte. Das entstehende HCl-Gas wurde in wässrige Natronlauge eingeleitet. Nach beendeter Zugabe wurde 10 min nachgerührt und anschließend auf Raumtemperatur abgekühlt. Das Reaktionsgemisch wurde auf 300 mL Eiswasser ausgetragen und die organische Phase abgetrennt. Die organische Phase wurde einmal mit 100 mL Wasser, einmal mit 100 mL 5% NaHCO₃-Lösung und erneut einmal mit 100 mL Wasser gewaschen. Der Tetrachlorkohlenstoff wurde abdestilliert und aus dem Öl kristallisierte das gewünschte Produkt (5.6 g) in Form farbloser feiner Nadeln aus.

### Beispiel 3: Herstellung von 1-Chlor-4,5-difluor-2-(trichlormethyl)benzol:

In einem 250 mL Vierhals-Rundkolben mit Rückfluss-Kühler, Tropftrichter, Innenthermometer und mechanischem Rührer wurden unter Stickstoff 27.4 g Aluminiumtrichlorid in 100 mL Tetrachlorkohlenstoff suspendiert. Zu dieser Suspension wurden 15.3 g 1-Chlor-3,4-difluorobenzol langsam zugeben, so dass das Reaktionsgemisch sanft refluxierte. Das entstehende HCl-Gas wurde in wässrige Natronlauge eingeleitet. Nach beendeter Zugabe wurde 10 min nachgerührt und anschließend auf Raumtemperatur abgekühlt. Das Reaktionsgemisch wurde auf 300 mL Eiswasser ausgetragen und die organische Phase abgetrennt. Die organische Phase wurde einmal mit 100 mL Wasser, einmal mit 100 mL 5% NaHCO₃-Lösung und erneut einmal mit 100 mL Wasser gewaschen. Der Tetrachlorkohlenstoff wurde abdestilliert und wenig Acetonitril zugesetzt. Aus dieser Lösung kristallisierte das gewünschte Produkt (6.0 g) in Form farbloser feiner Nadeln aus.

### Beispiel 4: Herstellung von 5-Chlor-1,2-difluor-3-(trichlormethyl)benzol:

Die Mutterlauge aus der Herstellung von Beispiel 3 wurde am Vakuum vom Acetonitril befreit und das verbliebene Öl (14.7 g) bestand aus dem isomeren 5-Chlor-1,2-difluor-3-(trichlormethyl)-benzol.

### Beispiel 5: Herstellung von 1-Brom-4,5-difluor-2-(trichlormethyl)benzol:

In einem 250 mL Vierhals-Rundkolben mit Rückfluss-Kühler, Tropftrichter, Innenthermometer und mechanischem Rührer wurden unter Stickstoff 27.4 g Aluminiumtrichlorid in 100 mL Tetrachlorkohlenstoff suspendiert. Zu dieser Suspension wurden 19.8 g 1-Brom-3,4-difluorobenzol langsam zugeben, so dass das Reaktionsgemisch sanft refluxierte. Das entstehende HCl-Gas wurde in wässrige Natronlauge eingeleitet. Nach beendeter Zugabe wurde 10 min nachgerührt und anschließend auf Raumtemperatur abgekühlt. Das Reaktionsgemisch wurde auf 300 mL Eiswasser ausgetragen und die organische Phase abgetrennt. Die organische Phase wurde einmal mit 100 mL Wasser, einmal mit 100 mL 5% NaHCO₃-Lösung und erneut einmal mit 100 mL Wasser gewaschen. Der Tetrachlorkohlenstoff wurde abdestilliert und wenig Acetonitril zugesetzt. Aus dieser Lösung kristallisierte das gewünschte Produkt (4.4 g) in Form farbloser feiner Nadeln aus.

### Beispiel 6: Herstellung von 5-Brom-1,2-difluor-3-(trichlormethyl)benzol:

Die Mutterlauge aus der Herstellung von Beispiel 5 wurde am Vakuum vom Acetonitril befreit und das verbliebene Öl (22.0 g) bestand aus dem isomeren 5-Brom-1,2-difluor-3-(trichlormethyl)-benzol.

### Beispiel 7: Herstellung von 1,4-Difluor-2-(trichlormethyl)benzol:

In einem 250 mL Vierhals-Rundkolben mit Rückfluss-Kühler, Tropftrichter, Innenthermometer und mechanischem Rührer wurden unter Stickstoff 27.4 g Aluminiumtrichlorid in 100 mL Tetrachlorkohlenstoff suspendiert. Zu dieser Suspension wurden 11.7 g 1,4-Difluorobenzol langsam zugeben, so dass das Reaktionsgemisch sanft refluxierte. Das entstehende HCl-Gas wurde in wässrige Natronlauge eingeleitet. Nach beendeter Zugabe wurde 10 min nachgerührt und anschließend auf Raumtemperatur abgekühlt. Das Reaktionsgemisch wurde auf 300 mL Eiswasser ausgetragen und die organische Phase abgetrennt. Die organische Phase wurde einmal mit 100 mL Wasser, einmal mit 100 mL 5% NaHCO₃-Lösung und erneut einmal mit 100 mL Wasser gewaschen. Der Tetrachlorkohlenstoff wurde abdestilliert und wenig Acetonitril zugesetzt. Aus dieser Lösung kristallisierte das gewünschte Produkt (8.0 g) in Form farbloser feiner Nadeln aus.

### Beispiel 8: Herstellung von 1-Chlor-4-fluor-2-(trichlormethyl)benzol und 4-Chlor-1-fluor-2-(trichlormethyl)benzol :

In einem 250 mL Vierhals-Rundkolben mit Rückfluss-Kühler, Tropftrichter, Innenthermometer und mechanischem Rührer wurden unter Stickstoff 27.4 g Aluminiumtrichlorid in 100 mL Tetrachlorkohlenstoff suspendiert. Zu dieser Suspension wurden 13.4 g 4-Chlorofluorobenzol langsam zugeben, so dass das Reaktionsgemisch sanft refluxierte. Das entstehende HCl-Gas wurde in wässrige Natronlauge eingeleitet. Nach beendeter Zugabe wurde 10 min nachgerührt und anschließend auf Raumtemperatur abgekühlt. Das Reaktionsgemisch wurde auf 300 mL Eiswasser ausgetragen und die organische Phase abgetrennt. Die organische Phase wurde einmal mit 100 mL Wasser, einmal mit 100 mL 5% NaHCO₃-Lösung und erneut einmal mit 100 mL Wasser gewaschen. Der Tetrachlorkohlenstoff wurde abdestilliert und wenig Acetonitril zugesetzt. Aus dieser Lösung fiel eine Mischung der gewünschte Produkte 1,4-Difluor-2-(trichlormethyl)benzol und 4-Chlor-1-fluor-2-(trichlormethyl)benzol (17.5 g) im Verhältnis von ca. 3:1 aus.

### Beispiel 9: Herstellung von 1,4-Difluor-2-(trichlormethyl)benzol:

In einem 250 mL Vierhals-Rundkolben mit Rückfluss-Kühler, Tropftrichter, Innenthermometer und mechanischem Rührer wurden unter Stickstoff 27.4 g Aluminiumtrichlorid in 100 mL Tetrachlorkohlenstoff suspendiert. Zu dieser Suspension wurden 18.0 g 4-Bromfluorbenzol langsam zugeben, so dass das Reaktionsgemisch sanft refluxierte. Das entstehende HCl-Gas wurde in wässrige Natronlauge eingeleitet. Nach beendeter Zugabe wurde 10 min nachgerührt und anschließend auf Raumtemperatur abgekühlt. Das Reaktionsgemisch wurde auf 300 mL Eiswasser ausgetragen und die organische Phase abgetrennt. Die organische Phase wurde einmal mit 100 mL Wasser, einmal mit 100 mL 5% NaHCO₃-Lösung und erneut einmal mit 100 mL Wasser gewaschen. Der Tetrachlorkohlenstoff wurde abdestilliert und wenig Acetonitril zugesetzt. Aus dieser Lösung kristallisierte das gewünschte Produkt (4.6 g) in Form farbloser feiner Nadeln aus.

### Herstellung der weiteren Komponenten für die Photopolymer-Formulierung:

### Herstellung von Polyol 1:

In einem 1 L Kolben wurden 0.18 g Zinnoctoat, 374.8 g ε-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

### Herstellung des Urethanacrylats 1 (Schreibmonomer): Phosphorothioyltris(oxybenzol-4,1-diylcarbamoyloxyethan-2,1-diyl)trisacrylat

In einem 500 mL Rundkolben wurden 0.1 g 2,6-Di-tert.-butyl-4-methylphenol, 0.05 g Dibutylzinn-dilaurat sowie und 213.07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und das Ethylacetat im Vakuum vollständig entfernt. Das Produkt wurde als teilkristalliner Feststoff erhalten.

### Herstellung des Urethanacrylats 2 (Schreibmonomer): 2-({[3-(Methylsulfanyl)phenyl]-carbamoyl}oxy)ethylprop-2-enoat

In einem 100 mL Rundkolben wurden 0.02 g 2,6-Di-tert.-butyl-4-methylphenol, 0.01 g Desmorapid Z, 11.7 g 3-(Methylthio)phenylisocyanat [28479-1-8] vorgelegt und auf 60 °C erwärmt. Anschließend wurden 8.2 g 2-Hydroxyethylacrylat zugetropft und die Mischung weiter auf 60 °C gehalten, bis der Isocyanatgehalt unter 0.1 % gesunken war. Danach wurde abgekühlt. Das Produkt wurde als farblose Flüssigkeit erhalten.

### Herstellung des Additivs 1 Bis(2,2,3,3,4,4,5,5,6,6,7,7-dodecafluorheptyl)-(2,2,4-trimethylhexan-1,6-diyl)biscarbamat

In einem 50 mL Rundkolben wurden 0.02 g Desmorapid Z und 3.6 g 2,4,4-Trimethylhexane-1,6-diisocyanat (TMDI) vorgelegt und auf 60 °C erwärmt. Anschließend wurden 11.9 g 2,2,3,3,4,4,5,5,6,6,7,7-Dodecafluorheptan-1-ol zugetropft und die Mischung weiter auf 60 °C gehalten, bis der Isocyanatgehalt unter 0.1 % gesunken war. Danach wurde abgekühlt. Das Produkt wurde als farbloses Öl erhalten.

### Herstellung des Borates 1 (Photoinitiator): Tetrabutylammonium-tris(4-chlorphenyl)(hexyl)borat

Zu einer Lösung von 15.4 g Dibrom-hexylboran*dimethylsulfid [64770-04-3] (hergestellt wie im Journal of the American Chemical Society (1977), 99, 7097-8 beschrieben) in 25 mL Toluol wurden bei 0 °C 72 mL einer 0.9 M Lösung von 4-Chlorphenylmagnesiumbromid [873-77-8] in THF/Toluol langsam zugetropft. Das Reaktionsgemisch wurde innerhalb 30 min auf Raumtemperatur erwärmt und anschließend für 2 h am Rückfluss erhitzt. Anschließend wurde das Lösungsmittel im Vakuum entfernt und der ölige Rest in 400 mL Methanol/Wasser (4:1) gelöst und vom ausgefallenen Feststoff filtriert. Die erhaltene Lösung wurde mit 15.6 g Tetrabutylammoniumbromid versetzt und der ausgefallene Feststoff wurde durch Filtration isoliert und im Vakuum getrocknet. Man erhielt 12.2 g eines farblosen Feststoffes.

### Herstellung des Borates 2 (Photoinitiator): Tetrabutylammonium-tris(4-fluorphenyl)(hexyl)borat

Zu einer Lösung von 12.5 g Dibrom-hexylboran*dimethylsulfid [64770-04-3] (hergestellt wie im Journal of the American Chemical Society (1977), 99, 7097-8 beschrieben) in 25 mL Toluol wurden bei 0 °C 60 mL einer 1.0 M Lösung von 4-Fluorphenylmagnesiumbromid [873-77-8] in THF langsam zugetropft. Das Reaktionsgemisch wurde innerhalb 30 min auf Raumtemperatur erwärmt und anschließend für 2 h am Rückfluss erhitzt. Anschließend wurde das Lösungsmittel im Vakuum entfernt und der ölige Rest in 400 mL Methanol/Wasser (4:1) gelöst und vom ausgefallenen Feststoff filtriert. Die erhaltene Lösung wurde mit 12.6 g Tetrabutylammoniumbromid versetzt und der ausgefallene Feststoff wurde durch Filtration isoliert und im Vakuum getrocknet. Man erhielt 10.2 g eines farblosen Feststoffes.

### Herstellung des Farbstoffs 1:

5.07 g wasserfreies Natrium-bis(2-ethylhexyl)sulfosuccinat [45297-26-5] wurden in 50 mL wasserfreiem Essigsäureethylester gelöst. 4.00 g des wasserfreien Farbstoffs Safranin O [10309-89-4], Zusammensetzung siehe EP 2450893 A1, wurden zugesetzt. Die Mischung wurde 3 h bei Raumtemperatur gerührt und über einen Faltenfilter filtriert. Nach Entfernen des Lösungsmittels im Vakuum erhielt 5.1 g des Farbstoffs Safranin O bis(2-ethylhexyl)sulfosuccinat [1374689-68-5] als hochviskoses Öl.

### Herstellung der Medien zur Bestimmung der holographischen Eigenschaften

### Beispiel-Medium I

3.38 g der Polyol-Komponente 1 wurden mit 0.010 g Beispiel 1, 2.00 g Urethanacrylat 1, 2.00 g Urethanacrylat 2, 1.50 g Additiv 1, 0.10 g Borat 1, 0.010 g Farbstoff 1 und 0.35 g N-Ethylpyrrolidon bei 60 °C gemischt, so dass eine klare Lösung erhalten wurde. Anschließend wurde auf 30 °C abgekühlt, 0.65 g Desmodur® N3900 zugegeben und erneut gemischt. Schließlich wurden 0.01 g Fomrez UL 28 zugegeben und erneut kurz gemischt. Die erhaltene, flüssige Masse wurde dann auf eine Glasplatte gegeben und dort mit einer zweiten Glasplatte abgedeckt. Dieser Probenkörper wurde 12 Stunden bei Raumtemperatur liegen gelassen und gehärtet.

### Beispiel-Medium II

Es wurde gearbeitet wie im Beispiel Medium I, aber unter Verwendung von 0.10 g Borat 2 anstatt 0.10 g Borat 1.

### Beispiel-Medium III

Es wurde gearbeitet wie im Beispiel Medium I, aber unter Verwendung von 0.010 g Beispiel 2 anstatt 0.010 g Beispiel 1.

### Beispiel-Medium IV

Es wurde gearbeitet wie im Beispiel Medium I, aber unter Verwendung von 0.010 g Beispiel 3 anstatt 0.010 g Beispiel 1 sowie unter Verwendung von 0.10 g Borat 2 anstatt 0.10 g Borat 1.

### Beispiel-Medium V

Es wurde gearbeitet wie im Beispiel Medium I, aber unter Verwendung von 0.010 g Beispiel 4 anstatt 0.010 g Beispiel 1.

### Beispiel-Medium VI

Es wurde gearbeitet wie im Beispiel Medium I, aber unter Verwendung von 0.010 g Beispiel 5 anstatt 0.010 g Beispiel 1.

### Beispiel-Medium VII

Es wurde gearbeitet wie im Beispiel Medium I, aber unter Verwendung von 0.010 g Beispiel 6 anstatt 0.010 g Beispiel 1.

### Beispiel-Medium VIII

Es wurde gearbeitet wie im Beispiel Medium I, aber unter Verwendung von 0.010 g Beispiel 7 anstatt 0.010 g Beispiel 1 sowie unter Verwendung von 0.10 g Borat 2 anstatt 0.10 g Borat 1.

### Beispiel-Medium IX

Es wurde gearbeitet wie im Beispiel Medium I, aber unter Verwendung von 0.010 g Beispiel 8 anstatt 0.010 g Beispiel 1 sowie unter Verwendung von 0.10 g Borat 2 anstatt 0.10 g Borat 1.

### Beispiel-Medium X

Es wurde gearbeitet wie im Beispiel Medium I, aber unter Verwendung von 0.010 g Beispiel 9 anstatt 0.010 g Beispiel 1.

### Vergleichs-Medium V-1

3.38 g der Polyol-Komponente 1 wurden mit 2.00 g Urethanacrylat 1, 2.00 g Urethanacrylat 2, 1.50 g Additiv 1, 0.10 g Borat 1, 0.010 g Farbstoff 1 und 0.35 g N-Ethylpyrrolidon bei 60 °C gemischt, so dass eine klare Lösung erhalten wurde. Anschließend wurde auf 30 °C abgekühlt, 0.65 g Desmodur® N3900 zugegeben und erneut gemischt. Schließlich wurden 0.01 g Fomrez UL 28 zugegeben und erneut kurz gemischt. Die erhaltene, flüssige Masse wurde dann auf eine Glasplatte gegeben und dort mit einer zweiten Glasplatte abgedeckt. Dieser Probenkörper wurde 12 Stunden bei Raumtemperatur liegen gelassen und gehärtet.

### Vergleichs-Medium V-2

Es wurde gearbeitet wie im Vergleichs-Medium V-1, aber unter Verwendung von 0.10 g Borat 2 anstatt 0.10 g Borat 1.

### Holographische Prüfung:

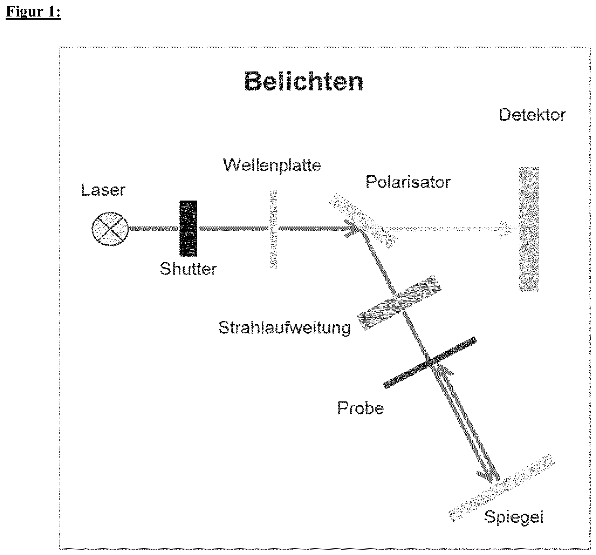

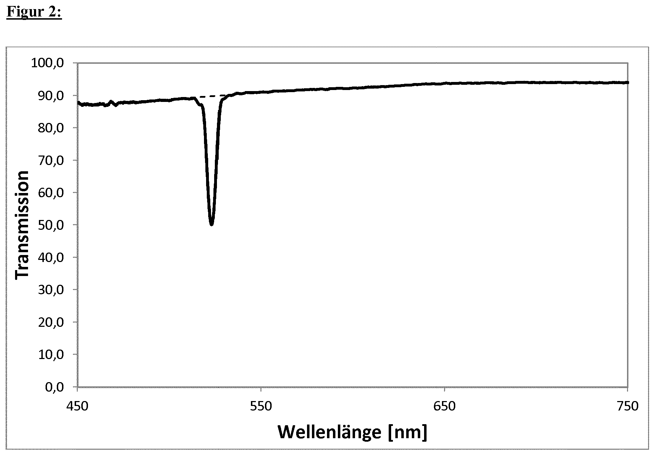

Die wie beschrieben hergestellten Medien wurden mittels einer Messordnung gemäß Figur 1 in der oben beschriebenen Weise (Bestimmung der Beugungseffizienz bei Puls-Belichtung) auf ihre holographischen Eigenschaften geprüft. Dabei ergaben sich folgende Messwerte für DE bei einer fixen Dosis 100 mJ/cm²:

**Tab. 1: Holographische Bewertung ausgewählter Beispiele**

| **Beispiel-Medium** | **Beispiel gemäß Formel (I)** | **Borat** | **Single pulse DE [%]** |
|---|---|---|---|
| I | 1 | 1 | 22 |
| II | 1 | 2 | 21 |
| III | 2 | 1 | 38 |
| IV | 3 | 2 | 37 |
| V | 4 | 1 | 29 |
| VI | 5 | 1 | 34 |
| VII | 6 | 1 | 19 |
| VIII | 7 | 2 | 24 |
| IX | 8 | 2 | 26 |
| X | 9 | 1 | 27 |

**Tab. 2: Holographische Bewertung ausgewählter Vergleichs-Medien**

| **Vergleichs-Medium** | **Additiv** | **Borat** | **Single pulse DE [%]** |
|---|---|---|---|
| V-1 | - | 1 | - |
| V-2 | - | 2 | - |

Die gefundenen Werte für die Beispiel-Medien I bis X zeigen, dass die in den Photopolymer-Formulierungen eingesetzten erfindungsgemäßen Verbindungen der Formel (I) für die Verwendung in holographischen Medien bei Belichtung mit gepulstem Laser sehr gut geeignet sind. Die Vergleichs-Medien V-1 und V-2 weisen keine erfindungsgemäßen Verbindung der Formel (I) auf und sind für die Verwendung in holographischen Medien bei Belichtung mit gepulstem Laser ungeeignet.

## Patentansprüche

1. Photopolymer-Formulierung umfassend Matrixpolymere, ein Schreibmonomer und einen Photoinitiator, **dadurch gekennzeichnet, dass** sie zusätzlich eine Verbindung der Formel (I) umfasst 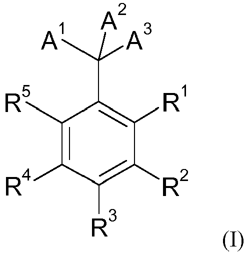 worin
A¹, A², A³ jeweils unabhängig voneinander Wasserstoff, Fluor, Chlor, Brom oder Iod,
R¹, R², R³, R⁴, R⁵ jeweils unabhängig voneinander Wasserstoff, Halogen, Cyano, Nitro, Isonitril, Acyl, Carboxyl, Carbonester, Carbonamid, Orthoester, Sulfonat, Phosphat, Organo-sulfonyl, Organo-sulfoxidyl, gegebenenfalls fluoriertes Alkoxy und bevorzugt Wasserstoff, Halogen, Cyano, Nitro, Isonitril, Acyl, Carboxyl, weiter bevorzugt Wasserstoff, Halogen und besonders bevorzugt Wasserstoff, Fluor, Chlor, Brom oder Iod sind und geeignete Reste über eine Brücke beliebiger Substitution miteinander verbunden sein können oder dass zwei oder mehrere Verbindungen der Formel (I) über mindestens einen der Reste R¹, R², R³, R⁴, R⁵ verbunden sein können, wobei diese Reste dann eine 2 - 4-fach funktionelle Brücke darstellen können, mit der Maßgabe, dass wenigstens einer der Reste R¹, R², R³, R⁴, R⁵ nicht Wasserstoff ist.

2. Photopolymer-Formulierung nach Anspruch 1, **dadurch gekennzeichnet, dass** A¹, A² und A³ jeweils unabhängig voneinander Fluor, Chlor, Brom oder Iod und bevorzugt A¹, A² und A³ gleichzeitig entweder Fluor, Chlor, Brom oder Iod sind.

3. Photopolymer-Formulierung nach einem der Ansprüche 1 bis 2, **dadurch gekennzeichnet, dass** die Matrixpolymere vernetzt und bevorzugt dreidimensional vernetzt sind.

4. Photopolymer-Formulierung nach einem der Ansprüche 1 bis 3, **dadurch gekennzeichnet, dass** die Matrixpolymere Polyurethane sind.

5. Photopolymer-Formulierung nach Anspruch 4, **dadurch gekennzeichnet, dass** die Polyurethane durch Umsetzung wenigstens einer Polyisocyanat-Komponente mit wenigstens einer Isocyanat-reaktiven-Komponente erhältlich sind.

6. Photopolymer umfassend Matrixpolymere, ein Schreibmonomer und einen Photoinitiator, **dadurch gekennzeichnet, dass** sie zusätzlich eine Verbindung der Formel (I) umfasst 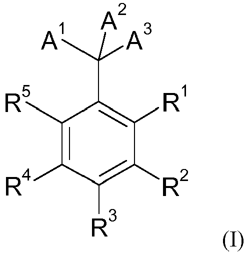 worin
A¹, A², A³ jeweils unabhängig voneinander Wasserstoff, Fluor, Chlor, Brom oder Iod,
R¹, R², R³, R⁴, R⁵ jeweils unabhängig voneinander Wasserstoff, Halogen, Cyano, Nitro, Isonitril, Acyl, Carboxyl, Carbonester, Carbonamid, Orthoester, Sulfonat, Phosphat, Organo-sulfonyl, Organo-sulfoxidyl, gegebenenfalls fluoriertes Alkoxy und bevorzugt Wasserstoff, Halogen, Cyano, Nitro, Isonitril, Acyl, Carboxyl, weiter bevorzugt Wasserstoff, Halogen und besonders bevorzugt Wasserstoff, Fluor, Chlor, Brom oder Iod sind und geeignete Reste über eine Brücke beliebiger Substitution miteinander verbunden sein können oder dass zwei oder mehrere Verbindungen der Formel (I) über mindestens einen der Reste R¹, R², R³, R⁴, R⁵ verbunden sein können, wobei diese Reste dann eine 2 - 4-fach funktionelle Brücke darstellen können, mit der Maßgabe, dass wenigstens einer der Reste R¹, R², R³, R⁴, R⁵ nicht Wasserstoff ist.

7. Photopolymer nach Anspruch 6, **dadurch gekennzeichnet, dass** A¹, A² und A³ jeweils unabhängig voneinander Fluor, Chlor, Brom oder Iod und bevorzugt A¹, A² und A³ gleichzeitig entweder Fluor, Chlor, Brom oder Iod sind.

8. Photopolymer nach einem der Ansprüche 6 bis 7, **dadurch gekennzeichnet, dass** die Matrixpolymere vernetzt und bevorzugt dreidimensional vernetzt sind.

9. Photopolymer nach einem der Ansprüche 6 bis 8, **dadurch gekennzeichnet, dass** die Matrixpolymere Polyurethane sind.

10. Photopolymer nach Anspruch 9, **dadurch gekennzeichnet, dass** die Polyurethane durch Umsetzung wenigstens einer Polyisocyanat-Komponente mit wenigstens einer Isocyanatreaktiven-Komponente erhältlich sind.

11. Holographisches Medium, insbesondere in Form eines Films, enthaltend eine Photopolymer gemäß wenigstens einem der Ansprüche 6 bis 10.

12. Holographisches Medium nach Anspruch 11, **dadurch gekennzeichnet, dass** holographische Informationen einbelichtet sind.

13. Verwendung eines holographischen Mediums gemäß Anspruch 11 zur Aufzeichnung von In-Line, Off-Axis, Full-Aperture Transfer, Weißlicht-Transmissions, Reflexions, Denisyuk, Off-Axis Reflektions oder Edge-Lit Hologrammen sowie holographischen Stereogrammen, insbesondere zur Herstellung von optischen Elementen, Bildern oder Bilddarstellungen.

14. Verfahren zur Herstellung eines holographischen Mediums gemäß Anspruch 11, wobei ein Träger aus einem eines für Licht im sichtbaren Spektralbereich transparenten Materials oder Materialverbunds mit einer Photopolymer-Formulierung gemäß wenigstens einem der Ansprüche 1 bis 5 ein- oder beidseitig beschichtet wird und bevorzugt eine Abdeckschicht auf der oder den Photopolymerlagen appliziert wird.

15. Verwendung einer Photopolymer-Formulierung nach einem der Ansprüche 1 bis 5 zur Herstellung holographischer Medien.

## Claims

1. Photopolymer formulation comprising matrix polymers, a writing monomer and a photoinitiator, **characterized in that** it further comprises a compound of formula (I) 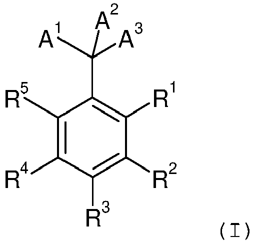 where
A¹, A² and A³ are each independently hydrogen, fluorine, chlorine, bromine or iodine,
R¹, R², R³, R⁴ and R⁵ are each independently hydrogen, halogen, cyano, nitro, isonitrile, acyl, carboxyl, carboxylic ester, carboxamide, orthoester, sulphonate, phosphate, organosulphonyl, organosulphoxidyl, optionally fluorinated alkoxy and preferably hydrogen, halogen, cyano, nitro, isonitrile, acyl, carboxyl, further preferably hydrogen, halogen and particularly preferably hydrogen, fluorine, chlorine, bromine or iodine and suitable radicals may be connected together via a bridge of any desired substitution, or **in that** two or more compounds of formula (I) may be connected together via at least one of the radicals R¹, R², R³, R⁴ and R⁵ , in which case these radicals therein constitute a 2- to 4-ply functional bridge, with the proviso that at least one of the radicals R¹, R², R³, R⁴ and R⁵ is not hydrogen.

2. Photopolymer formulation according to Claim 1, **characterized in that** A¹, A² and A³ are each independently fluorine, chlorine, bromine or iodine and preferably A¹, A² and A³ are all either fluorine, chlorine, bromine or iodine.

3. Photopolymer formulation according to any of Claims 1 to 2, **characterized in that** the matrix polymers are in a crosslinked and preferably three-dimensionally crosslinked state.

4. Photopolymer formulation according to any of Claims 1 to 3, **characterized in that** the matrix polymers are polyurethanes.

5. Photopolymer formulation according to Claim 4, **characterized in that** the polyurethanes are obtainable by reacting at least one polyisocyanate component with at least one isocyanate-reactive component.

6. Photopolymer comprising matrix polymers, a writing monomer and a photoinitiator, **characterized in that** it further comprises a compound of formula (I) 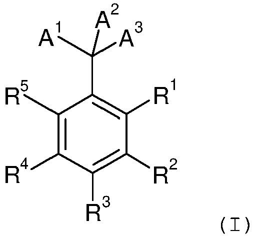 where
A¹, A² and A³ are each independently hydrogen, fluorine, chlorine, bromine or iodine,
R¹, R², R³, R⁴ and R⁵ are each independently hydrogen, halogen, cyano, nitro,, isonitrile, acyl, carboxyl, carboxylic ester, carboxamide, orthoester, sulphonate, phosphate, organosulphonyl, organosulphoxidyl, optionally fluorinated alkoxy and preferably hydrogen, halogen, cyano, nitro, isonitrile, acyl, carboxyl, further preferably hydrogen, halogen and particularly preferably hydrogen, fluorine, chlorine, bromine or iodine and suitable radicals may be connected together via a bridge of any desired substitution, or **in that** two or more compounds of formula (I) may be connected together via at least one of the radicals R¹, R², R³, R⁴ and R⁵, in which case these radicals therein constitute a 2- to 4-ply functional bridge, with the proviso that at least one of the radicals R¹, R², R³, R⁴ and R⁵ is not hydrogen.

7. Photopolymer according to Claim 6, **characterized in that** A¹, A² and A³ are each independently fluorine, chlorine, bromine or iodine and more preferably A¹, A² and A³ are all either fluorine, chlorine, bromine or iodine.

8. Photopolymer according to any of Claims 6 to 7, **characterized in that** the matrix polymers are in a crosslinked and preferably three-dimensionally crosslinked state.

9. Photopolymer according to any of Claims 6 to 8, **characterized in that** the matrix polymers are polyurethanes.

10. Photopolymer according to Claim 9, **characterized in that** the polyurethanes are obtainable by reaction of at least one polyisocyanate component with at least one isocyanate-reactive component.

11. Holographic medium, in particular in the form of a film, comprising a photopolymer according to at least one of Claims 6 to 10.

12. Holographic medium according to Claim 11, **characterized in that** holographic information has been exposed.

13. Use of a holographic medium according to Claim 11 for recording of in-line, off-axis, full-aperture transfer, white light transmission, reflection, Denisyuk, off-axis reflection or edge-lit holograms and also of holographic stereograms, in particular for production of optical elements, images or image depictions.

14. Process for producing a holographic medium according to Claim 11, wherein a carrier of a material or material composite transparent to light within the visible spectral range is coated on one or both sides with a photopolymer formulation according to at least one of Claims 1 to 5, and a cover layer is preferably applied to the photopolymer ply or plies.

15. Use of a photopolymer formulation according to any of Claims 1 to 5 for production of holographic media.

## Revendications

1. Formulation de photopolymère comprenant des polymères de matrice, un monomère d'écriture et un photoinitiateur, **caractérisée en ce qu'**elle comprend de plus un composé de formule (I) 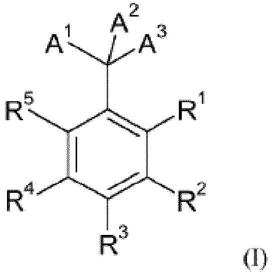 dans laquelle
A¹, A², A³ à chaque fois indépendamment les uns des autres sont hydrogène, fluor, chlore, brome ou iode,
R¹, R², R³, R⁴, R⁵ à chaque fois indépendamment les uns des autres sont hydrogène, halogène, cyano, nitro, isonitrile, acyle, carboxyle, ester carbonique, amide carbonique, ortho ester, sulfonate, phosphate, organosulfonyle, organosulfoxydyle, alcoxy éventuellement fluoré et préférablement hydrogène, halogène, cyano, nitro, isonitrile, acyle, carboxyle, plus préférablement hydrogène, halogène et particulièrement préférablement hydrogène, fluor, chlore, brome ou iode et des radicaux appropriés peuvent être reliés l'un à l'autre par l'intermédiaire d'un pont d'une quelconque substitution ou **en ce que** deux ou plusieurs composés de formule (I) peuvent être reliés par l'intermédiaire d'au moins un des radicaux R¹, R², R³, R⁴, R⁵, ces radicaux pouvant alors représenter un pont 2 à 4 fois fonctionnel, étant entendu qu'au moins un des radicaux R¹, R², R³, R⁴, R⁵ n'est pas hydrogène.

2. Formulation de photopolymère selon la revendication 1, **caractérisée en ce que** A¹, A² et A³ sont, à chaque fois indépendamment les uns des autres, fluor, chlore, brome ou iode et préférablement A¹, A² et A³ sont en même temps soit fluor, soit chlore, soit brome, soit iode.

3. Formulation de photopolymère selon l'une quelconque des revendications 1 et 2, **caractérisée en ce que** les polymères de matrice sont réticulés et préférablement sont réticulés de manière tridimensionnelle.

4. Formulation de photopolymère selon l'une quelconque des revendications 1 à 3, **caractérisée en ce que** les polymères de matrice sont des polyuréthanes.

5. Formulation de photopolymère selon la revendication 4, **caractérisée en ce que** les polyuréthanes peuvent être obtenus par transformation d'au moins un composant de type polyisocyanate avec au moins un composant réactif envers isocyanate.

6. Photopolymère comprenant des polymères de matrice, un monomère d'écriture et un photoinitiateur, **caractérisé en ce qu'**il comprend de plus un composé de formule (I) 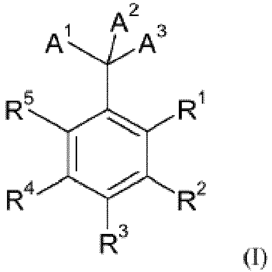 dans laquelle
A¹, A², A³ à chaque fois indépendamment les uns des autres sont hydrogène, fluor, chlore, brome ou iode,
R¹, R², R³, R⁴, R⁵ à chaque fois indépendamment les uns des autres sont hydrogène, halogène, cyano, nitro, isonitrile, acyle, carboxyle, ester carbonique, amide carbonique, ortho ester, sulfonate, phosphate, organosulfonyle, organosulfoxydyle, alcoxy éventuellement fluoré et préférablement hydrogène, halogène, cyano, nitro, isonitrile, acyle, carboxyle, plus préférablement hydrogène, halogène et particulièrement préférablement hydrogène, fluor, chlore, brome ou iode et des radicaux appropriés peuvent être reliés l'un à l'autre par l'intermédiaire d'un pont d'une quelconque substitution ou **en ce que** deux ou plusieurs composés de formule (I) peuvent être reliés par l'intermédiaire d'au moins un des radicaux R¹, R², R³, R⁴, R⁵, ces radicaux pouvant alors représenter un pont 2 à 4 fois fonctionnel, étant entendu qu'au moins un des radicaux R¹, R², R³, R⁴, R⁵ n'est pas hydrogène.

7. Photopolymère selon la revendication 6, **caractérisé en ce que** A¹, A² et A³ sont, à chaque fois indépendamment les uns des autres, fluor, chlore, brome ou iode et préférablement A¹, A² et A³ sont en même temps soit fluor, soit chlore, soit brome, soit iode.

8. Photopolymère selon l'une quelconque des revendications 6 et 7, **caractérisé en ce que** les polymères de matrice sont réticulés et préférablement sont réticulés de manière tridimensionnelle.

9. Photopolymère selon l'une quelconque des revendications 6 à 8, **caractérisé en ce que** les polymères de matrice sont des polyuréthanes.

10. Photopolymère selon la revendication 9, **caractérisé en ce que** les polyuréthanes peuvent être obtenus par transformation d'au moins un composant de type polyisocyanate avec au moins un composant réactif envers isocyanate.

11. Moyen holographique, en particulier sous la forme d'un film, contenant un photopolymère selon au moins l'une quelconque des revendications 6 à 10.

12. Moyen holographique selon la revendication 11, **caractérisé en ce que** des informations holographiques sont exposées.

13. Utilisation d'un moyen holographique selon la revendication 11 pour l'enregistrement d'hologrammes en ligne, hors axe, de transfert à pleine ouverture, de transmission de lumière blanche, de réflexion, de Denisyuk, de réflexion hors axe ou à éclairage périphérique ainsi que de stéréogrammes holographiques, en particulier pour la préparation d'éléments, d'images ou de représentations d'images optiques.

14. Procédé pour la préparation d'un moyen holographique selon la revendication 11, un support composé d'un matériau ou d'un matériau composite transparent à la lumière dans le domaine spectral visible étant revêtu d'un côté ou des deux côtés par une formulation de photopolymère selon au moins l'une quelconque des revendications 1 à 5 et préférablement une couche de couverture étant appliquée sur la ou les couches de photopolymère.

15. Utilisation d'une formulation de photopolymère selon l'une quelconque des revendications 1 à 5 pour la préparation de moyens holographiques.
